# EUROPÄISCHE PATENTANMELDUNG

(11) **EP 1 780 796 A1**
(43) Veröffentlichungstag der Anmeldung: **02.05.2007**
(21) Anmeldenummer: 05109991.9
(22) Anmeldetag: 26.10.2005
(51) Int. Cl.: H01L 27/146, H01L 27/148, H01L 31/0352

(54) **Verfahren zur Erfassung von Daten mit einem Bildsensor**

(71) Anmelder: DEUTSCHE THOMSON-BRANDT GMBH, 78048 Villingen-Schwenningen (DE)
(72) Erfinder: Ballweg, Christof, 78050, VS-Villingen (DE); Knittel, Joachim, 78052, VS-Villingen (DE)
(74) Vertreter: Thies, Stephan

(57) **Zusammenfassung**

Die Erfindung betrifft ein Verfahren zur Erfassung von Daten mit einem Bildsensor, bei dem ein optisches Speichermedium, das binäre Informationen in Form von zumindest einer zweidimensionalen Datenseite erhält, mit einem Laserstrahlenbündel belichtet und die belichtete Datenseite mit einem Bildsensor ausgelesen wird, wozu dieser über eine aktivierbare, eine Vielzahl von Pixeln aufweisende Fläche verfügt. Sie löst die Aufgabe, ein derartiges Verfahren so zu gestalten, dass das Auslesen der Informationen bei gleich bleibender Pixelzahl beschleunigt wird. Dazu ist die aktivierbare Fläche (3) des Bildsensors (2) in verschiedene Bereiche (2.1, 2.2) unterteilt, die jeweils einem Bereich mit einer bestimmten Intensität des Lichtstrahls zugeordnet sind. Für Bereiche (2.2), die Bereichen mit geringerer Intensität zugeordnet sind, ist dabei eine längere Belichtungszeit und/oder eine höhere Empfindlichkeit bestimmt als für Bereiche (2.1), die Bereichen mit einer höheren Intensität zugeordnet sind.

## Beschreibung

Die Erfindung betrifft ein Verfahren zur Erfassung von Daten mit einem Bildsensor, insbesondere von Daten aus einem holographischen Speichersystem, und einen Bildsensor für ein solches Verfahren.

Derartige Bildsensoren weisen als zentralen Baustein ein zweidimensionales in Zeilen oder als Matrix ausgebildetes ladungsgekoppeltes Halbleiterbauelement zur Verarbeitung elektrischer und optischer Signale auf. Der Bildsensor nimmt die Informationen in Form von Daten durch das Erfassen von Lichtstrahlung (Objektlicht) und Erzeugung elektrischer Ladungen auf und leitet diese weiter. Dazu weist dieser ein Feld von bis zu einigen Millionen Pixeln (Gate-Elektroden) auf, die das empfangene Licht in elektrische Signale umwandeln. Zudem wandelt ein Analog/Digitalspeicher diese elektrischen Signale in digitale Signale um, die unmittelbar zur Verfügung stehen und in Datenspeichereinheiten gespeichert werden.

Derartige Bildsensoren werden auch bei optischen, insbesondere holographischen Speichersystemen, bei denen Informationen in Form von Datenseiten in einer zweidimensionalen Datenfläche oder einem dreidimensionalen Datenvolumen eines Speichermediums (Platte, Karte) gespeichert werden, eingesetzt, um gespeicherte Daten unter Belichtung des Speichermediums mit einem Laserstrahlbündel wieder aufzufinden und zu erfassen.

Im Allgemeinen haben Laserstrahlbündel eine inhomogene, insbesondere Gauß'sche Intensitätsverteilung, welche mit einer inhomogenen Belichtung der auf dem Speichermedium beaufschlagten Datenseite, einem aus dieser Belichtung resultierenden inhomogenen Kontrast auf dieser und in der Folge auch mit einer inhomogenen Intensitätsverteilung auf dem während einer Belichtung aktivierten Bildsensor verbunden ist. Dieses wird als nachteilig angesehen, da das Auslesen der in der Datenseite enthaltenen Informationen durch den Bildsensor gleichzeitig erfolgt und in den kontrastärmeren Gebieten länger dauert, was mit einer Erhöhung der Belichtungszeit verbunden ist.

Aufgabe der Erfindung ist, bei einem Verfahren zur Erfassung von Daten mit einem Bildsensor nach dem Oberbegriff des Anspruchs 1 bei gleich bleibender Pixelzahl das Auslesen der Informationen zu beschleunigen. Eine weitere Aufgabe der Erfindung ist, einen für das Verfahren geeigneten Bildsensor vorzuschlagen.

Diese Aufgabe wird bei einem Verfahren nach dem Oberbegriff des Anspruchs 1 durch dessen kennzeichnende Merkmale gelöst. Vorteilhafte Ausgestaltungen sind in den Unteransprüchen aufgeführt.

Die Erfindung besteht in der Weiterentwicklung eines bekannten Verfahrens zur Erfassung von Daten mit einem Bildsensor. Der Bildsensor ist dabei ein Halbleiterbauelement, vorzugsweise ein CMOS-Bildsensor oder auch ein CCD-Bildsensor. Bei diesem Verfahren wird ein optisches (holgraphisches) Speichermedium, das binäre Informationen in zumindest einer zweidimensionalen Datenseite enthält, mit einem Laserstrahlbündel belichtet. Die belichtete Datenseite wird mit dem Bildsensor mit einer zweidimensionalen aktivierten Fläche in einer vorbestimmten Zeit ausgelesen. Es wird nun vorgeschlagen, das aktive (bzw. aktivierbare) Gebiet des Bildsensors in verschiedene Bereiche zu unterteilen, denen in Abhängigkeit von der Belichtungsintensität und dem Kontrast auf der Datenseite, hervorgerufen durch die inhomogene Intensitätsverteilung des Laserstrahlbündels, unterschiedliche Eigenschaften zugeordnet sind. Die Eigenschaften sind vorzugsweise unterschiede Belichtungszeiten oder unterschiedliche Empfindlichkeiten. Einem Bereich auf der Datenseite mit einer geringeren Belichtungsintensität und demzufolge einem geringerem Kontrast wird ein aktives Gebiet des Bildsensors mit einer höheren Belichtungszeit oder einer höheren Empfindlichkeit zugeordnet. Einem Bereich mit einer höheren Belichtungsintensität und einem höheren Kontrast wird ein aktives Gebiet des Bildsensors mit einer niedrigeren Belichtungszeit oder einer niedrigeren Empfindlichkeit zugeordnet. Selbstverständlich können auch unterschiedliche Belichtungszeiten mit unterschiedlichen Empfindlichkeiten kombiniert werden.

Der Vorteil liegt darin, dass im Falle von unterschiedlichen Belichtungszeiten die Datenauslese in den Gebieten mit einer hohen Belichtungsintensität früher erfolgen kann als in den Gebieten mit einer geringeren Belichtungsintensität und damit auch die Datenverarbeitung. Daher kann das Verfahren derart durchgeführt werden, dass die aktiven Gebiete mit der kürzeren Belichtungszeit bereits ausgelesen werden, wenn die aktiven Gebiete mit der längeren Belichtungszeit noch belichtet werden. Der Datentransfer wird effizienter. Die Anzahl der Pixel braucht nicht erhöht zu werden. Im Falle von unterschiedlichen Empfindlichkeiten kann die Datenauslese in allen Gebieten gleichzeitig erfolgen. Dabei ist die erforderliche Belichtungszeit kürzer als bei einem herkömmlichen Bildsensor, so dass die Datenauslese beschleunigt wird.

Die unterschiedlichen Bereiche sind nach der Intensitätsverteilung des Laserstrahlbündels und damit auch in Abhängigkeit von der optischen Achse ausgebildet. Dabei haben die Bereiche nahe der optischen Achse eine kürzere Belichtungszeit oder eine geringere Empfindlichkeit als die achsferneren Bereiche. Die Form der Bereiche hängt ab von der Intensitätsverteilung des Laserstrahlbündels. Vorzugsweise folgen die Begrenzungen eines Bereichs einer bestimmten Intensität des Laserstrahlbündels. In der einfachsten Ausgestaltung ist ein innerer Bereich nahe der optischen Achse quadratisch oder rechteckig. In einer an eine elliptische Intensitätsverteilung angepassten Ausgestaltung ist ein innerer Bereich vorzugsweise kreisförmig oder elliptisch. Dies wird beispielsweise durch verschiedene miteinander verbundene rechteckige oder quadratische Bereiche angenähert. Eine Festlegung der Bereiche erfolgt vorteilhafterweise derart, dass einem ersten Bereich alle Pixel zugeordnet werden, die mit mindestens einem festgelegten Anteil innerhalb eines Bereichs des Laserstrahlbündels liegen, in dem eine erste Lichtintensität überschritten ist. Einem zweiten Bereich werden alle Pixel zugeordnet, die mit mindestens einem festgelegten Anteil innerhalb eines Bereichs des Laserstrahlbündels liegen, in dem eine zweite, niedrigere Lichtintensität überschritten ist, und die nicht bereits dem ersten Bereich zugeordnet sind. Weitere Bereiche werden bei Bedarf entsprechend festgelegt.

Gemäß einem weiteren Aspekt der Erfindung werden die Bereiche nach gleichzeitigem Belichtungsbeginn, d.h. nach gleichzeitiger Aktivierung, spiralförmig von innen nach außen ausgelesen. Auch in diesem Fall werden die Bereiche unterschiedlich lang belichtet, diejenigen im Zentrum kürzer als die weiter außen liegenden. Diese Form des Auslesens ist insbesondere vorteilhaft, wenn der Bildsensor in eine Vielzahl sehr kleiner Bereiche unterteilt ist. Der kleinste mögliche Bereich ist dabei ein einzelner Pixel. Die Auslesespirale ist dabei vorteilhaft rechteckig oder abgerundet. Dies ist geometrisch einfacher zu realisieren als eine möglichst exakte Annäherung an eine ideale Spirale.

Ein erfindungsgemäßes Verfahren beziehungsweise ein erfindungsgemäßer Bildsensor wird vorteilhafterweise in einem Gerät zum Lesen und/oder Beschreiben optischer, insbesondere holographischer Speichermedien verwendet.

Die Erfindung wird anhand eines Ausführungsbeispiels erläutert. In den zugehörigen Zeichnungen zeigen:
- Fig. 1:: eine Anordnung mit einer einen Bildsensor aufweisenden Kamera zur Durchführung des Verfahrens,
- Fig. 2.: den aktiven Bereich des eingesetzten Bildsensors,
- Fig. 3:: ein Zeitdiagramm desselben, und
- Fig. 4:: ein weiteres Beispiel des aktiven Bereichs eines Bildsensors.

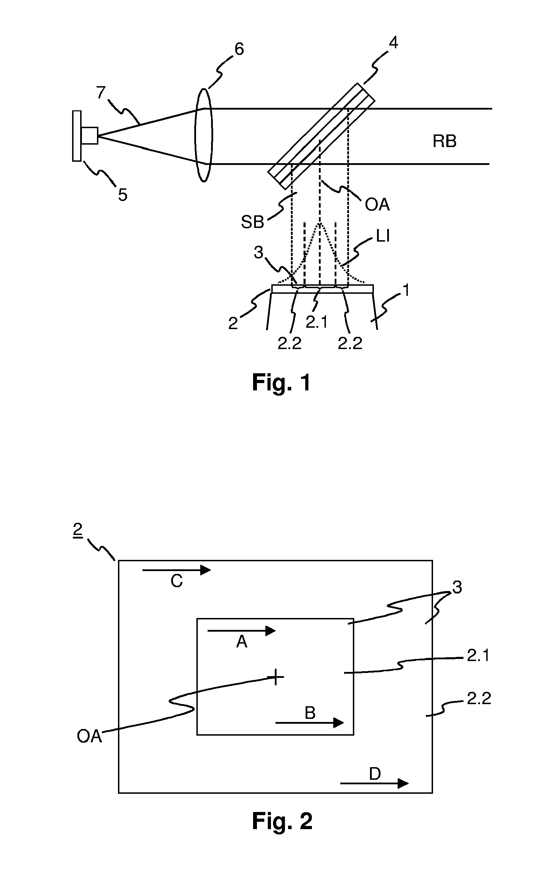

Die in Fig. 1 gezeigte Anordnung weist eine Kamera 1 mit einem CMOS-Bildsensor 2 mit einer aktiven (bzw. aktivierbaren) Fläche 3, die einem optischen (holographischen) Speichermedium 4 zugewandt ist, und einen Laser 5 auf. Diesem ist eine Sammellinse 6 zugeordnet, die die vom Laser 5 ausgestrahlten Laserstrahlen 7 zu einem Referenzstrahlenbündel RB bündelt. Aus dem Referenzstrahlenbündel RB wird durch das holographische Speichermedium 4 ein Signalstrahlenbündel SB generiert. Durch das Signalstrahlenbündel SB werden die Informationen, die im Speichermedium 4 enthalten und zuvor eingebracht worden sind, auf dem Bildsensor abgebildet und können ausgelesen werden. Fig. 1 lässt auch die Verteilung der Lichtintensität LI auf der aktivierten Fläche des Bildsensors erkennen, die sich aus einer inhomogenen, insbesondere Gauß'schen, Intensitätsverteilung des Laserstrahlenbündels ergibt. In Abhängigkeit von der Lichtintensität LI auf der aktivierten Fläche des Bildsensors sind dieser Fläche verschiedene Bereiche (2.1, 2.2) zugeordnet.

Im Beispiel der Fig. 1 trifft das Referenzstrahlbündel RB unter einem Winkel von 45° auf das Speichermedium 4. Es sind aber auch andere Winkel, beispielsweise 90°, möglich. Desweiteren sind auch Speichermedien bekannt, die nicht in Transmission, sondern in Reflexion ausgelesen werden.

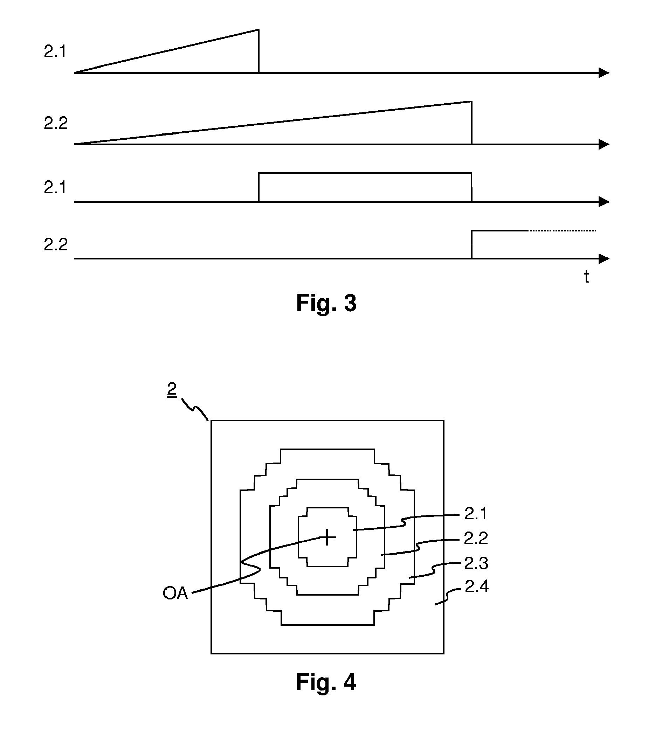

In der in Fig. 2 gezeigten aktivierbaren Fläche 3 des Bildsensors 2 sind ein Bereich 2.1 für eine kurze Belichtungszeit oder eine niedrige Empfindlichkeit, der rechteckig ausgebildet ist und im Bereich der optischen Achse 0A der Anordnung liegt, und ein diesen umgebender achsferner Bereich 2.2 für eine längere Belichtungszeit oder eine höhere Empfindlichkeit ausgebildet. Die Pfeile geben die Daten-Ausleserichtung und die Zeilenfolge A bis C der Daten-Aufnahme an. Dabei werden beide Bereiche 2.1 und 2.2 gleichzeitig aktiviert und beginnen gleichzeitig, die erhaltenen optischen Informationen in elektrische Signale umzuwandeln. Im Falle unterschiedlicher Belichtungszeiten wird die Belichtungszeit im Bereich 2.1 infolge des höheren Kontrastes auf der im Speichermediums 4 gespeicherten Datenseite kürzer bestimmt und beträgt beispielsweise die Hälfte der Belichtungszeit des Belichtungsbereiches 2.2. Daher kann nach Ende der Belichtungszeit im Bereich 2.1 mit der Datenauswertung begonnen werden, während der Bereich 2.2 noch belichtet wird. Diese zeitliche Abfolge ist in Fig. 3 schematisch dargestellt, wobei im oberen Teil die Signalstärke der Bereiche und im unteren Teil der Auslesezeitraum dargestellt sind. Im Falle unterschiedlicher Empfindlichkeiten erfolgt die Datenauswertung gleichzeitig in beiden Bereichen 2.1, 2.2. Selbstverständlich kann der Bildsensor auch mehr als zwei Bereiche aufweisen.

In Fig. 4 ist ein weiteres Beispiel des aktiven Bereichs eines Bildsensors gezeigt. In diesem Fall weist der Bildsensor vier an eine kreisförmige Gauß'sche Intensitätsverteilung angepasste Bereiche 2.1, 2.2, 2.3, 2.4 auf. Die eigentlich erforderlichen kreisförmigen beziehungsweise ringförmigen Bereiche werden dabei durch miteinander verbundene rechteckige und quadratische Bereiche angenähert.

### Bezugszeichenliste

- 1: Kamera
- 2: Bildsensor
- 2.1: Bereich
- 2.2: Bereich
- 2.3: Bereich
- 2.4: Bereich
- 3: Fläche
- 4: Speichermedium
- 5: Laser
- 6: Sammellinse
- 7: Laserstrahl
- A-C: Zeile
- LI: Lichtintensität
- OA: optische Achse
- RB: Referenzstrahlenbündel
- SB: Signalstrahlenbündel

## Patentansprüche

1. Bildsensor, der eine aktivierbare, eine Vielzahl von Pixeln aufweisende Fläche zum Auslesen von in einem Lichtstrahl enthaltenen Informationen hat, **dadurch gekennzeichnet, dass** die aktivierbare Fläche (3) des Bildsensors (2) in zwei oder mehr Bereiche (2.1, 2.2, 2.3, 2.4) mit unterschiedlichen Eigenschaften unterteilt ist, die jeweils einem Bereich des Lichtstrahls mit einer bestimmten Intensität zugeordnet sind.

2. Bildsensor nach Anspruch 1, **wobei** die unterschiedlichen Eigenschaften unterschiedliche Belichtungszeiten und/oder unterschiedliche Empfindlichkeiten sind.

3. Bildsensor nach Anspruch 1 oder 2, **wobei** einem Bereich des Lichtstrahls mit einer hohen Intensität ein Bereich des Bildsensors mit einer kurzen Belichtungszeit und/oder einer niedrigen Empfindlichkeit zugeordnet ist, und einem Bereich des Lichtstrahls mit einer niedrigen Intensität ein Bereich des Bildsensors mit einer langen Belichtungszeit und/oder einer hohen Empfindlichkeit zugeordnet ist.

4. Bildsensor nach einem der Ansprüche 1 bis 3, **wobei** der Bildsensor (2) ein CMOS-Bildsensor oder ein CCD-Bildsensor ist.

5. Verfahren zur Erfassung von Daten mit einem Bildsensor mit einer aktivierbaren Fläche mit einer Vielzahl von Pixeln, bei dem ein optischer Speicher, der binäre Informationen in Form von zumindest einer zweidimensionalen Datenseite enthält, mit einem Laserstrahlenbündel belichtet und die belichtete Datenseite mit dem Bildsensor ausgelesen wird, **dadurch gekennzeichnet, dass** die aktivierbare Fläche (3) in zwei oder mehr Bereiche (2.1, 2.2, 2.3, 2.4) unterteilt ist, die getrennt voneinander mit unterschiedlichen Parametern ausgelesen werden.

6. Verfahren nach Anspruch 5, **wobei** unterschiedliche Bereiche (2.1, 2.2, 2.3, 2.4) unterschiedlich lang belichtet werden, bevor sie ausgelesen werden.

7. Verfahren nach Anspruch 6, **wobei** die Bereiche mit einer kurzen Belichtungszeit bereits ausgelesen werden, wenn die Bereiche mit einer langen Belichtungszeit noch belichtet werden.

8. Verfahren nach Anspruch 6 oder 7, **wobei** die Bereiche spiralförmig von innen nach außen oder von außen nach innen ausgelesen werden.

9. Verfahren nach Anspruch 5, **wobei** die unterschiedlichen Bereiche (2.1, 2.2, 2.3, 2.4) mit unterschiedlicher Empfindlichkeit ausgelesen werden.

10. Gerät zum Lesen und/oder Beschreiben optischer, insbesondere holographischer Speichermedien, **dadurch gekennzeichnet, dass** es einen Bildsensor gemäß einem der Ansprüche 1 bis 4 oder Mittel zum Durchführen eines Verfahrens gemäß einem der Ansprüche 5 bis 9 aufweist.
